# EUROPEAN PATENT APPLICATION

(11) **EP 4 528 822 A1**
(43) Date of publication of application: **26.03.2025**
(21) Application number: 23819166.2
(22) Date of filing: 07.06.2023
(51) Int. Cl.: H01L 29/778, H01L 27/088, H01L 29/06, H01L 21/8234, H05K 1/18

(54) **SEMICONDUCTOR DEVICE AND ELECTRONIC EQUIPMENT**

(30) Priority: 09.06.2022 CN 202210644648
(71) Applicant: Huawei Technologies Co., Ltd., Shenzhen, Guangdong 518129 (CN)
(72) Inventor: HOU, Mingchen, Shenzhen, Guangdong 518129 (CN); WEI, Wei, Shenzhen, Guangdong 518129 (CN); HE, Linfeng, Shenzhen, Guangdong 518129 (CN); ZHANG, Yawen, Shenzhen, Guangdong 518129 (CN)
(74) Representative: Pfenning, Meinig & Partner mbB
(86) International application number: PCT/CN2023/098886
(87) International publication number: WO 2023/237001

(57) **Abstract**

This application provides a semiconductor device and an electronic device. The semiconductor device includes a substrate and a plurality of structural units, and the plurality of structural units are all disposed on one side of the substrate. Each of the structural units includes a source, a drain, a fin, and a gate, the sources of the structural units are connected, the drains of the structural units are connected, and the gates of the structural units are connected. In each of the structural units, projections of the source and the drain on the substrate are respectively located on two sides of a projection of the gate on the substrate, the fin is disposed on the substrate, and a projection of the fin on the substrate is located within a range of the projection of the gate on the substrate. A fin of a first structural unit and a fin of a second structural unit in the plurality of structural units differ in size. In this application, a quantity of transconductance levels of the semiconductor device can be increased.

## Description

This application claims priority to Chinese Patent Application No. 202210644648.7, filed with the China National Intellectual Property Administration on June 9, 2022, and entitled "SEMICONDUCTOR DEVICE AND ELECTRONIC DEVICE", which is incorporated herein by reference in its entirety.

### TECHNICAL FIELD

This application relates to the field of semiconductor technologies, and in particular, to a semiconductor device and an electronic device.

### BACKGROUND

Rapid development of industries such as 5G communication imposes higher requirements on a power amplifier. When linearity of the power amplifier is too low, severe problems such as sidebands, output power saturation at high input power, and signal distortion may be caused. Therefore, during actual application, it is desirable to obtain a power amplifier with high linearity.

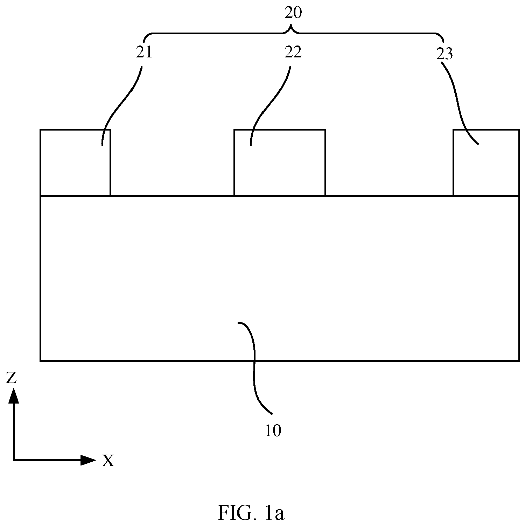

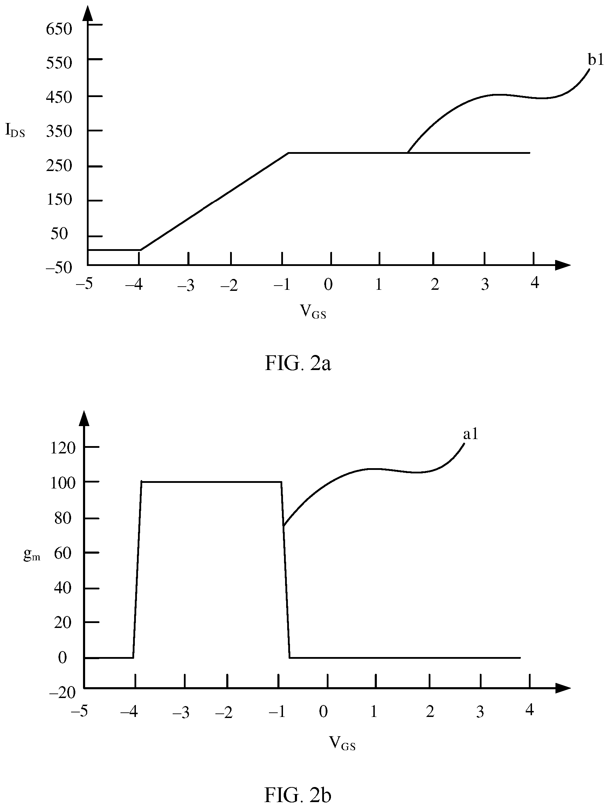

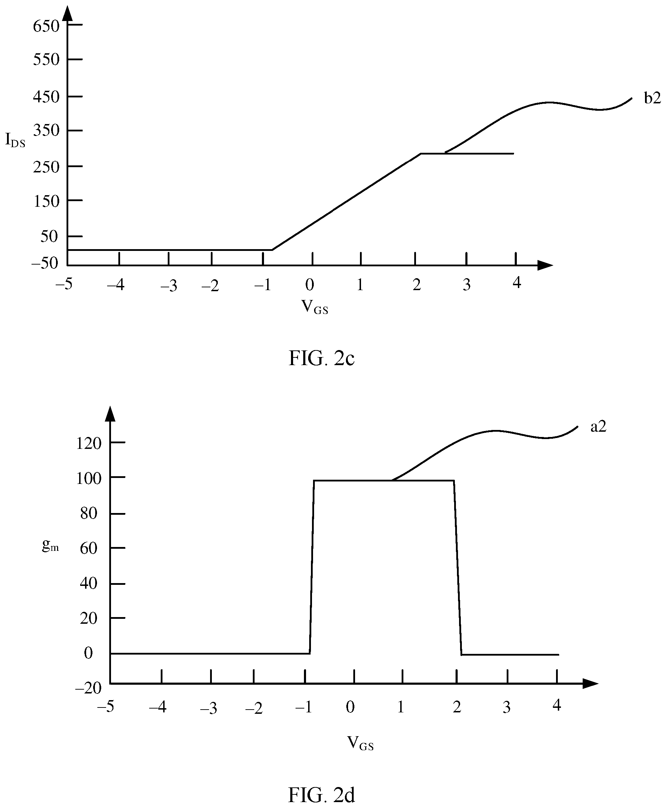

The power amplifier is a semiconductor device, and the semiconductor device is electrically connected to a circuit board. As shown in FIG. 1a, the semiconductor device includes a substrate 10 and a structural unit 20, and the structural unit 20 includes a source 21, a gate 22, and a drain 23. Transconductance of the semiconductor device changes with a gate-source voltage, seriously affecting the linearity of the power amplifier. As shown in FIG. 2b and FIG. 2d, as a voltage between the gate 22 and the source 21 rises, transconductance curves a1 and a2 show a trend that the transconductance first increases and then decreases. Consequently, the linearity of the power amplifier is low.

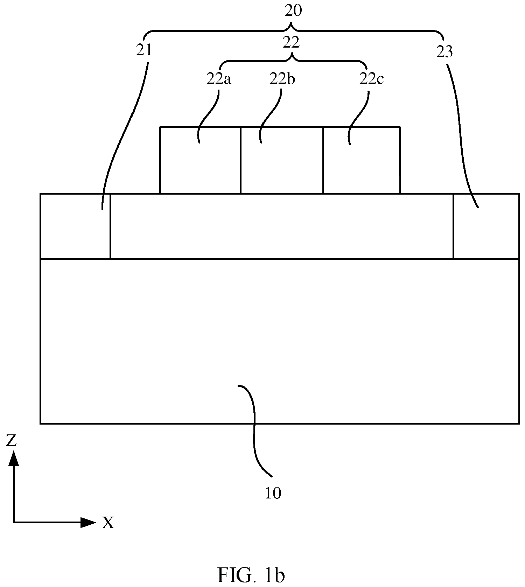

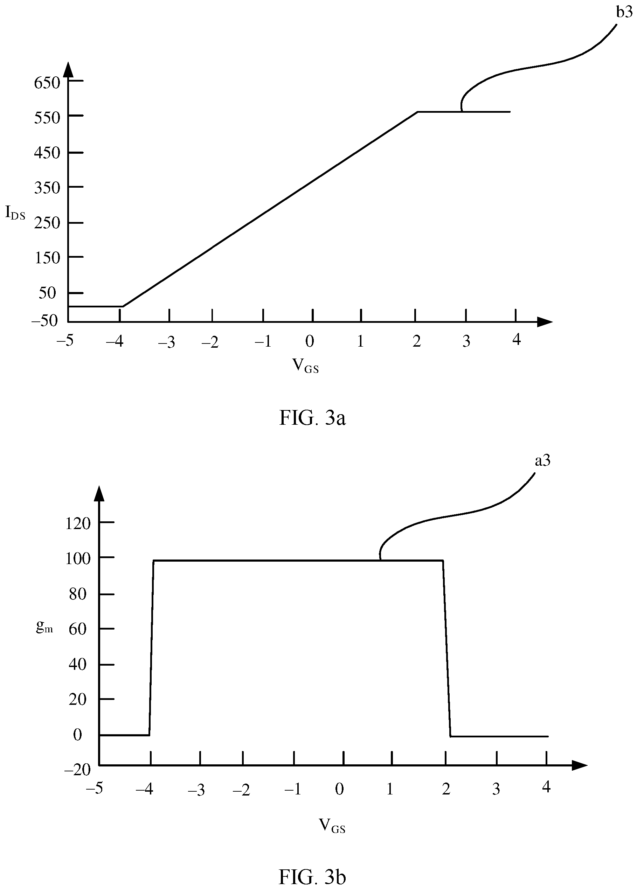

In a conventional technology, a method based on transconductance compensation is usually used to improve the linearity of the power amplifier. Specifically, as shown in FIG. 1b, different materials are set for different regions of the gate in a length direction (X direction) of the gate 22. For example, a gate 22a, a gate 22b, and a gate 22c are respectively made of different materials. In this way, threshold voltages of different regions of the structural unit are different, thereby implementing transconductance compensation. The structural unit having different threshold voltages may obtain a plurality of transconductance curves a1, a2, and the like. A plurality of different threshold voltages of the structural unit indicates a plurality of transconductance levels of the semiconductor device, and the plurality of transconductance curves a1, a2, and the like are fused to obtain a transconductance curve a3 of the semiconductor device. For example, the transconductance curve a3 shown in FIG. 3b is a transconductance curve obtained after the transconductance curve a1 shown in transconductance curve FIG. 2b and the transconductance curve a2 shown in FIG. 2d are fused. It may be learned from FIG. 3b that a larger quantity of transconductance levels indicates the smoother middle of the transconductance curve a3 and higher linearity of the power amplifier.

However, with improvement of a frequency characteristic of the power amplifier, a length of the gate gradually decreases. Due to a limitation imposed by a requirement for photoetching precision, a quantity of transconductance levels that can be implemented within a length range of the gate is limited. Therefore, how to implement more transconductance levels to obtain a smooth transconductance curve in a large range in the middle is an urgent technical problem to be resolved currently.

### SUMMARY

To resolve the foregoing technical problem, this application provides a semiconductor device and an electronic device, to increase a quantity of transconductance levels of the semiconductor device.

This application provides a semiconductor device. The semiconductor device includes a substrate and a plurality of structural units, and the plurality of structural units are all disposed on one side of the substrate. Each of the structural units includes a source, a drain, a fin, and a gate, where the sources of the structural units are connected, the drains of the structural units are connected, and the gates of the structural units are connected. In each of the structural units, projections of the source and the drain on the substrate are respectively located on two sides of a projection of the gate on the substrate, the fin is disposed on the substrate, and a projection of the fin on the substrate is located within a range of the projection of the gate on the substrate. A fin of a first structural unit and a fin of a second structural unit in the plurality of structural units differ in size.

Transconductance of the structural unit is a ratio of a change value of a current between the drain and the source to a change value of a voltage between the gate and the source. A transconductance curve is a change trend curve of the transconductance with a change of the voltage between the gate and the source. Usually, a horizontal coordinate is the voltage between the gate and the source, and a vertical coordinate is the transconductance. A size of the fin affects a threshold voltage of the structural unit, and consequently affects the transconductance curve. When the size of the fin changes, a transconductance amplitude of the structural unit changes, and a position of the transconductance curve in the horizontal coordinate changes. When the fin of the first structural unit and the fin of the second structural in the plurality of structural units differ in size, positions of transconductance curves of the two structural units in the horizontal coordinate are different in a coordinate system. Therefore, the semiconductor device in this application includes at least two transconductance levels, and transconductance curves of at least two structural units can be obtained. After the transconductance curves of the two structural units are fused, a smooth transconductance curve in the middle may be obtained, and the transconductance curve is a transconductance curve of the semiconductor device. In addition, sizes of fins of a large quantity of structural units may be set to be different, to obtain more transconductance levels, thereby obtaining a smooth transconductance curve in a large range in the middle, and improving linearity of the semiconductor device.

In some possible implementations, sizes of the fins of each of the structural units are different. In this way, a position of the transconductance curve of each of the structural units is different in the coordinate system. Therefore, the semiconductor device may obtain at least a same quantity of transconductance curves as that of the structural units. This may further increase the quantity of transconductance levels of the semiconductor device.

In some possible implementations, the size of the fin includes at least one of a size in a first direction, a size in a second direction, and a size in a thickness direction, and both the first direction and the second direction are perpendicular to the thickness direction. The size in the first direction, the size in the second direction, and the size in the thickness direction of the fin all affect the position of the transconductance curve of the structural unit in the coordinate system. Therefore, during design, the fins of the structural units may be selected to differ in size in any direction, or the fins of the structural units may be selected to differ in size in the first direction, the second direction, and the thickness direction. This may further increase the quantity of transconductance levels of the semiconductor device. In addition, when the fins of the structural units differ in size in the first direction and/or the second direction, because both the first direction and the second direction are perpendicular to the thickness direction, the fins of the structural units may be manufactured under a same etching process when the semiconductor device in this application is manufactured. Therefore, the quantity of transconductance levels of the semiconductor device may be increased without increasing a process flow.

In some possible implementations, a first distance between the gate and the source in the first structural unit is different from the first distance in the second structural unit. When first distances between gates and sources of two structural units are different, resistance values of the two structural units are different, and a transconductance amplitude is negatively correlated with a resistance value. Therefore, transconductance amplitudes of the two structural units are different, and positions of highest points of the transconductance curves of the two structural units in the vertical coordinate are also different. When fins of two structural units differ in size, transconductance amplitudes of the two structural units are different, and positions of transconductance curves in a horizontal coordinate are different. Therefore, when impact of the different first distances between the gates and the sources in the two structural units on the transconductance amplitudes is opposite to impact of the different sizes of the fins on the transconductance amplitudes, it can be ensured as much as possible that a middle region is smooth after the transconductance curves of the two structural units are fused. Therefore, this can also make the middle of the transconductance curve of the semiconductor device be smooth.

In some possible implementations, the first distances in each of the structural units are different. In this way, transconductance amplitudes of the structural units are different. In other words, positions of transconductance curves of the structural units in a vertical coordinate are different. Therefore, the semiconductor device may obtain at least a same quantity of transconductance curves as that of the structural units. When a position of the transconductance curve of each of the structural units in a horizontal coordinate is also different, the middle of the transconductance curve of the semiconductor device may be further made smoother.

In some possible implementations, a second distance between the gate and the drain in the first structural unit is different from the second distance in the second structural unit. Because the semiconductor device is usually of a symmetric structure with a center of the semiconductor device, a case in which the semiconductor device is incorrectly assembled may exist. Because the source and the drain are made of a same material, when the semiconductor device is incorrectly assembled, the source may be used as the drain, and the drain may also be used as the source. In this case, when the second distance between the gate and the drain in the first structural unit is different from the second distance in the second structural unit, the distance between the gate and the source in the first structural unit can still different from the distance between the gate and the source in the second structural unit. Therefore, the middle of the transconductance curve of the semiconductor device can be smooth.

In some possible implementations, the second distances in each of the structural units are different. In this way, transconductance amplitudes of the structural units are different. In other words, positions of transconductance curves of the structural units in a vertical coordinate are different. Therefore, the semiconductor device may obtain at least a same quantity of transconductance curves as that of the structural units. When a position of the transconductance curve of each of the structural units in a horizontal coordinate is also different, the middle of the transconductance curve of the semiconductor device may be further made smoother.

In some possible implementations, the semiconductor device includes at least two electrodes, and the two electrodes are disposed on a first surface that is of the substrate and that is away from the structural units. A projection of the gate in the first structural unit on the first surface overlaps with one of the electrodes, and a projection of the gate in the second structural unit on the first surface overlaps with another of the electrodes. When the semiconductor device is used, different voltages may be applied to the two electrodes respectively, and the voltages may be transferred to regions that are of the substrate and that correspond to the electrodes, so that the substrate in different regions has different voltages of the substrate. The threshold voltage of the structural unit is negatively correlated with the voltage of the substrate. Because the projection of the gate in the first structural unit on the first surface overlaps with one of the electrodes, and the projection of the gate in the second structural unit on the first surface overlaps with another of the electrodes, the threshold voltages of the two structural units are different. Therefore, another method for regulating the threshold voltage of the structural unit may be provided.

In some possible implementations, a quantity of electrodes is the same as a quantity of structural units, and projections of the electrodes on the first surface are in one-to-one correspondence with projections of the gates in the structural units on the first surface. When the semiconductor device is used, different voltages may be applied to the electrodes respectively, and the voltages may be transferred to regions that are of the substrate and that correspond to the electrodes, so that the substrate in different regions has different voltages of the substrate. The threshold voltage of the structural unit is negatively correlated with the voltage of the substrate. Because the projections of the electrodes on the first surface are in one-to-one correspondence with and overlap with the projections of the gates in the structural units on the first surface, the threshold voltages of each of the structural units are different. Therefore, another method for regulating the threshold voltage of the structural unit may be provided.

In some possible implementations, the plurality of structural units are arranged in the first direction. In at least one of the structural units, the source, the gate, and the drain are all arranged in the first direction and extend in the second direction, there are a plurality of fins, the plurality of fins are arranged in an extension direction of the gate, and there is an included angle between the second direction and the first direction. In this way, the plurality of structural units may form a multi-finger structure, and there are a plurality of fins in at least one of the structural units. Therefore, sizes of the plurality of fins in the structural unit may be further set to different sizes, so that one structural unit obtains a plurality of threshold voltages, and the structural unit obtains a plurality of transconductance levels, thereby further increasing the quantity of transconductance levels of the semiconductor device.

In some possible implementations, in at least one of the structural units, a shape of the projection of at least one of the gate, the source, and the drain on the substrate is a ring; and there are a plurality of fins, and the plurality of fins are arranged in an extension direction of the gate. There are a plurality of fins in at least one of the structural units. Therefore, sizes of the plurality of fins in the structural unit may be further set to different sizes, so that one structural unit obtains a plurality of threshold voltages, and the structural unit obtains a plurality of transconductance levels, thereby further increasing the quantity of transconductance levels of the semiconductor device.

In some possible implementations, in at least one of the structural units, a size of the gate in the first direction is positively correlated with the size of the fin in the first direction, and the first direction is perpendicular to the extension direction of the gate. Because the projection of the fin on the substrate is located within the range of the projection of the gate on the substrate, and the size of the fin in the first direction affects the transconductance amplitude of the structural unit, when the size of the gate in the first direction increases, the transconductance amplitude of the structural unit decreases. Therefore, after the size of the fin in the first direction is determined, the size of the gate in the first direction may be determined, thereby reducing waste of the gate and impact on performance of the semiconductor device caused by an increase in the size of the gate in the first direction when the size of the fin in the first direction is reduced.

In some possible implementations, in at least one of the structural units, the size of the fin in the first direction is less than the size of the gate in the first direction. In this way, the gate in the unit structure may wrap the fin, so that a capability of controlling a channel by the gate can be increased, electric leakage of the semiconductor device is reduced, and stability of a threshold voltage of the structural unit is improved.

In some possible implementations, in at least one of the structural units, a shape of the projection of at least one of the gate, the source, and the drain on the substrate is a ring-shaped polygon; and there are a plurality of fins, the gate includes a plurality of sub-gates that are sequentially connected end to end, a projection of each of the sub-gates on the substrate surrounds projections of the plurality of fins on the substrate, and the plurality of fins are arranged in an extension direction of the sub-gate. There are a plurality of fins in at least one of the structural units. Therefore, sizes of the plurality of fins in the structural unit may be further set to different sizes, so that one structural unit obtains a plurality of threshold voltages, and the structural unit obtains a plurality of transconductance levels, thereby further increasing the quantity of transconductance levels of the semiconductor device.

In some possible implementations, in at least one of the structural units, a size of the sub-gate in the first direction is positively correlated with the size of the fin in the first direction, and the first direction is perpendicular to the extension direction of the sub-gate. Because the projection of the fin on the substrate is located within the range of the projection of the gate on the substrate, and the size of the fin in the first direction affects the transconductance amplitude of the structural unit, when the size of the sub-gate in the first direction increases, the transconductance amplitude of the structural unit decreases. Therefore, after the size of the fin in the first direction is determined, the size of the sub-gate in the first direction may be determined, thereby reducing waste of the sub-gate and impact on performance of the semiconductor device caused by an increase in the size of the sub-gate in the first direction when the size of the fin in the first direction is reduced.

In some possible implementations, in at least one of the structural units, a shape of the projection of at least one of the gate, the source, and the drain on the substrate is a ring-shaped regular polygon. When the shape of the projection of the gate on the substrate is a ring-shaped regular polygon, edges of every two adjacent structural units may be attached to each other, so that utilization of a material of the substrate by the plurality of structural units can be increased, and waste of the material of the substrate can be reduced. Similarly, when the shape of the projection of the source and/or the drain on the substrate is a ring-shaped regular polygon, utilization of the material of the substrate by the plurality of structural units can also be increased, and waste of the material of the substrate can be reduced.

In some possible implementations, a spacing between two adjacent fins in the first structural unit is different from a spacing between two adjacent fins in the second structural unit. When the spacings between two adjacent fins in two structural units are different, threshold voltages of the two structural units are also different. Therefore, another method for regulating a threshold voltage of a structural unit may be provided. This can reduce difficulty in processing caused by use of a single factor to regulate a threshold voltage of each of the structural units.

In some possible implementations, the spacings in each of the structural units are different. Therefore, another method for regulating a threshold voltage of a structural unit may be provided. This can reduce difficulty in processing caused by use of a single factor to regulate a threshold voltage of each of the structural units.

This application further provides an electronic device, including a circuit board and the semiconductor device according to any one of the foregoing implementations. The semiconductor device is electrically connected to the circuit board. The electronic device can implement all effect of the semiconductor device.

### BRIEF DESCRIPTION OF DRAWINGS

To describe technical solutions in embodiments of this application more clearly, the following briefly introduces the accompanying drawings used in describing embodiments of this application. It is clear that the accompanying drawings in the following descriptions show merely some embodiments of this application, and a person of ordinary skill in the art may still derive other drawings from these accompanying drawings without creative efforts.
FIG. 1a is a diagram of a structure of a semiconductor device in a conventional technology;
FIG. 1b is a diagram of another structure of a semiconductor device in a conventional technology;
FIG. 2a is a diagram of a transfer characteristic curve of a structural unit;
FIG. 2b is a diagram of a transconductance curve of the structural unit corresponding to FIG. 2a;
FIG. 2c is a diagram of a transfer characteristic curve of another structural unit;
FIG. 2d is a diagram of a transconductance curve of the structural unit corresponding to FIG. 2c;
FIG. 3a is a diagram of a transfer characteristic curve of a semiconductor device including the structural unit corresponding to FIG. 2a and the structural unit corresponding to FIG. 2b;
FIG. 3b is a diagram of a transconductance curve of the semiconductor device corresponding to FIG. 3a;
FIG. 4a is a diagram of a structure of a semiconductor device according to an embodiment of this application;
FIG. 4b is a diagram of a three-dimensional structure of a semiconductor device according to an embodiment of this application;
FIG. 5a is a diagram of a structure of a semiconductor device according to an embodiment of this application;
FIG. 5b is a diagram of a structure of a semiconductor device according to an embodiment of this application;
FIG. 6 is a B-B sectional view of FIG. 5a;
FIG. 7 is a diagram of a structure of a semiconductor device according to an embodiment of this application;
FIG. 8 is a C-direction view of FIG. 5a;
FIG. 9 is a diagram of transconductance curves of a plurality of structural units;
FIG. 10a is an A-A sectional view of FIG. 6;
FIG. 10b is a cross-sectional diagram of the semiconductor device shown in FIG. 4a;
FIG. 11 is a D-D sectional view of FIG. 6;
FIG. 12 is another C-direction view of FIG. 5a;
FIG. 13 is a diagram of a structure of a semiconductor device and a circuit board according to an embodiment of this application;
FIG. 14 is a diagram of a structure of a semiconductor device and a circuit board according to an embodiment of this application;
FIG. 15 is a diagram of a structure of a semiconductor device and a circuit board according to an embodiment of this application;
FIG. 16 is a diagram of a structure of a semiconductor device according to an embodiment of this application;
FIG. 17 is an E-E sectional view of FIG. 16;
FIG. 18 is a diagram of a structure of a semiconductor device according to an embodiment of this application;
FIG. 19 is a partial enlarged view of a position F in FIG. 18; and
FIG. 20 is a diagram of a structure of a semiconductor device according to an embodiment of this application.

Reference numerals:
10: substrate; 11: first surface; 12: second surface; 20: structural unit; 21: source; 22: gate; 221: sub-gate; 23: drain; 24: fin; 30: channel layer; 31: 2DEG; 40: barrier layer; 50: electrode; 61: source connection part; 62: gate connection part; 63: drain connection part; 71: first dielectric layer; 72: second dielectric layer; 73: air bridge; 81: power supply; 82: voltage divider; 83: resistor.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship between associated objects and represents that three relationships may exist. For example, A and/or B may represent the following three cases: Only A exists, both A and B exist, and only B exists.

In the specification and claims in embodiments of this application, the terms "first", "second", and the like are intended to distinguish between different objects, but do not indicate a specific sequence of the objects. For example, a first target object, a second target object, and the like are intended to distinguish between different target objects, but do not indicate a specific sequence of the target objects.

In embodiments of this application, the term such as "example" or "for example" is used to represent an example, an illustration, or a description. Any embodiment or design scheme described by an "example" or "for example" in embodiments of this application should not be explained as being more preferred or having more advantages than another embodiment or design scheme. To be precise, use of the term such as "example" or "for example" is intended to present a related concept in a specific manner.

In the descriptions of embodiments of this application, unless otherwise specified, "a plurality of" means two or more. For example, a plurality of processing units are two or more processing units, and a plurality of systems are two or more systems.

In the descriptions of embodiments of this application, "transconductance" means transconductance of a semiconductor device, and is usually a ratio of a change value of a current between a drain and a source to a change value of a voltage between a gate and the source. A "transconductance curve" is a change trend curve of the transconductance with a change of the voltage between the gate and the source. Usually, a horizontal coordinate (for example, V_{GS}) is the voltage between the gate and the source, and a vertical coordinate (for example, gₘ) is the transconductance.

Curves shown in FIG. 2a and FIG. 2c are transfer characteristic curves of a semiconductor device, where a horizontal coordinate V_{GS} is a voltage between a gate and a source, and a vertical coordinate I_{DS} is a current between a drain and the source. A threshold voltage of a structural unit in the semiconductor device shown in FIG. 2a is different from a threshold voltage of a structural unit in the semiconductor device shown in FIG. 2c. Because "transconductance" is usually a ratio of a change value of a current between a drain and a source to a change value of a voltage between a gate and the source, after a slope of each point in the transfer characteristic curve is taken, transconductance corresponding to each voltage V_{GS} between a gate and a source may be obtained. For example, a transconductance curve a1 in FIG. 2b is a curve obtained after a slope of each point in the transfer characteristic curve b1 shown in FIG. 2a is taken, and a transconductance curve a2 in FIG. 2d is a curve obtained after a slope of each point in the transfer characteristic curve b2 shown in FIG. 2c is taken. It may be learned by comparing FIG. 2b and FIG. 2d that positions of the transconductance curve a1 and the transconductance curve a2 in the horizontal coordinate are different. It may be learned that, when threshold voltages of two structural units are different, transconductance curves corresponding to the two structural units are located at different positions in the horizontal coordinate.

A transfer characteristic curve b3 shown in FIG. 3a is a transfer characteristic curve of the semiconductor device. The semiconductor includes two structural units. A transfer characteristic curve corresponding to one structural unit is the transfer characteristic curve b1 shown in FIG. 2a, and a transfer characteristic curve corresponding to the other structural unit is the transfer characteristic curve b2 shown in FIG. 2c. Therefore, the transfer characteristic curve b3 shown in FIG. 3a is a transfer characteristic curve obtained after the transfer characteristic curve b1 and the transfer characteristic curve b2 are fused. A transconductance curve a3 shown in FIG. 3b is a transconductance curve obtained after the transconductance curve a1 shown in FIG. 2b and the transconductance curve a2 shown in FIG. 2d are fused. It may be learned from FIG. 3b that, compared with the transconductance curve a1 and the transconductance curve a2, the transconductance curve a3 has a larger smooth range in the middle. Because the semiconductor device in FIG. 3b includes two structural units having different threshold voltages, a quantity of transconductance levels of the semiconductor device is 2. It may be learned from FIG. 3b that, a larger quantity of transconductance levels of the semiconductor device indicates a large smooth range of the transconductance curve in the middle.

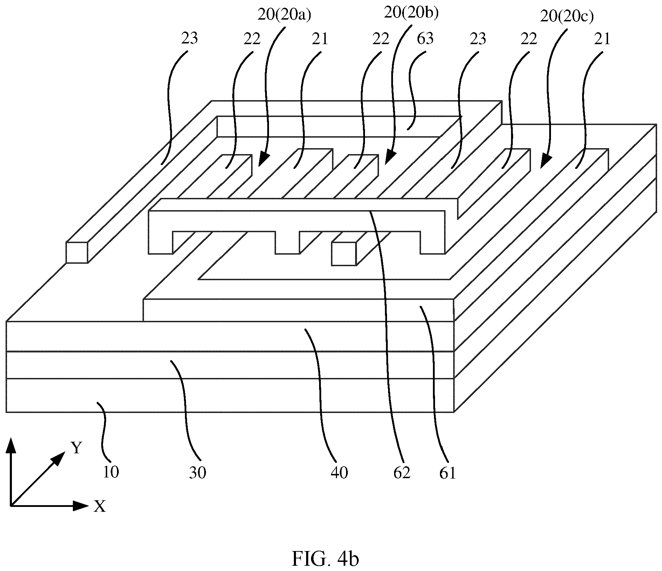

For ease of description, as shown in FIG. 4b, three directions may be defined: a first direction (X direction), indicating a length direction of the semiconductor device; a second direction (Y direction), indicating a width direction of the semiconductor device; and a third direction (Z direction), indicating a thickness direction of the semiconductor device.

Rapid development of industries such as 5G communication imposes higher requirements on a power amplifier. When linearity of the power amplifier is too low, severe problems such as sidebands, output power saturation at high input power, and signal distortion may be caused. Therefore, during actual application, it is desirable to obtain a power amplifier with high linearity.

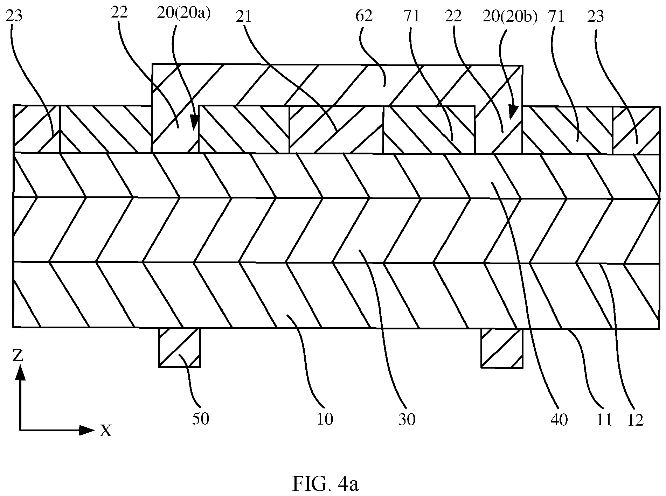

An embodiment of this application provides a semiconductor device. The semiconductor device may be used in the foregoing power amplifier, or may be used in another electronic device, for example, a low noise amplifier. As shown in FIG. 4a, the semiconductor device includes a substrate 10, a channel layer 30, a barrier layer 40, a plurality of structural units 20, and a plurality of electrodes 50. It should be noted that the semiconductor device may further include another layer, for example, a buffer layer or a cap layer. When the semiconductor device further includes the buffer layer, the buffer layer may be located between the substrate 10 and the channel layer 30. When the semiconductor device further includes the cap layer, the cap layer may be located between the barrier layer 40 and the structural units 20.

Each structural unit 20 includes a source 21, a drain 23, a fin 24 (not shown in FIG. 4a), and a gate 22. In an embodiment, the plurality of structural units 20 are mutually connected in parallel. It should be understood that "the plurality of structural units 20 are mutually connected in parallel" in this application may mean that the sources 21 of the structural units 20 are connected, the drains 23 of the structural units 20 are connected, and the gates 22 of the structural units 20 are connected. For example, the source 21 of each of the structural units 20 extends from a connection position to the Y direction, and/or the drain 23 of each of the structural units 20 extends from a connection position to the Y direction, and/or the gate 22 of each of the structural units 20 extends from a connection position to the Y direction. In an embodiment, FIG. 4a shows two structural units 20, namely, a first structural unit 20a and a second structural unit 20b, of the semiconductor device. A source 21 of the first structural unit 20a and a source 21 of the second structural unit 20b are in contact and manufactured as a whole. Therefore, in other words, the first structural unit 20a and the second structural unit 20b share the source 21. In another embodiment, FIG. 4b shows three structural units 20, namely, a first structural unit 20a, a second structural unit 20b, and a third structural unit 20c, of the semiconductor device. A source 21 of the first structural unit 20a is connected to a source 21 of the second structural unit 20b, and a drain 23 of the second structural unit 20b is connected to a drain 23 of the third structural unit 20c.

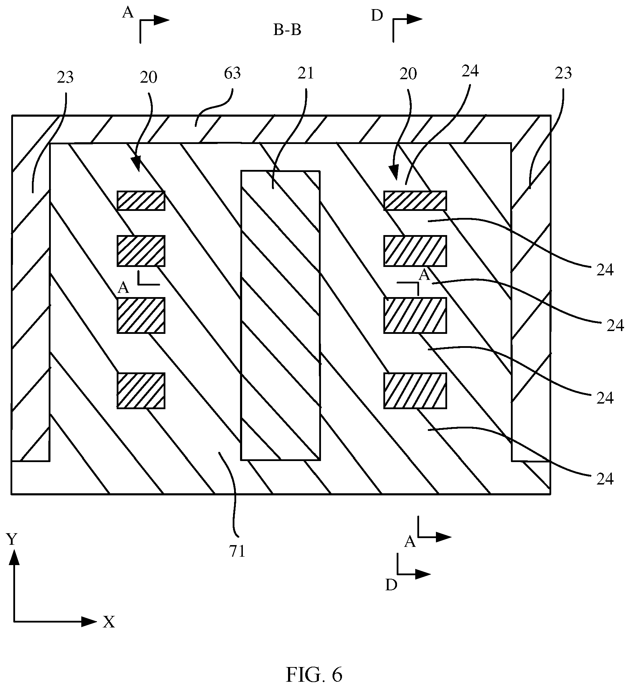

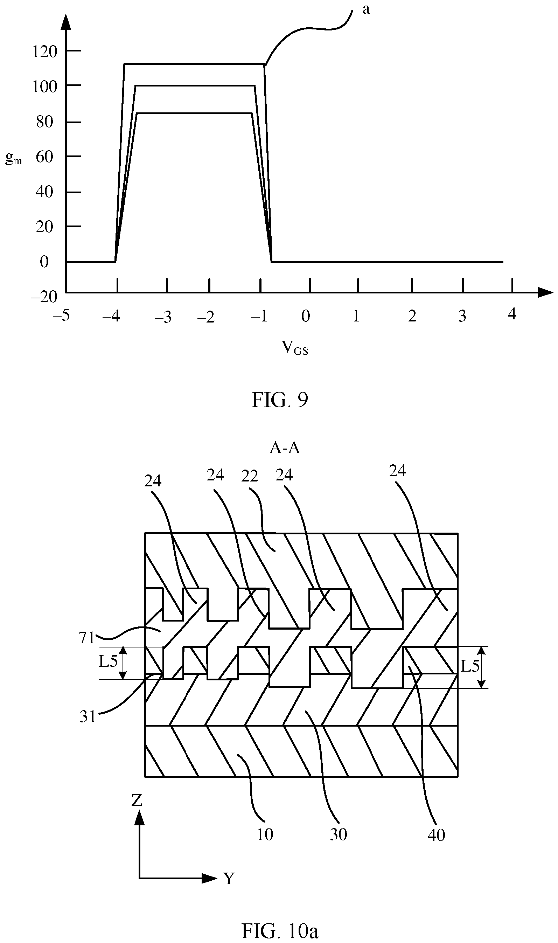

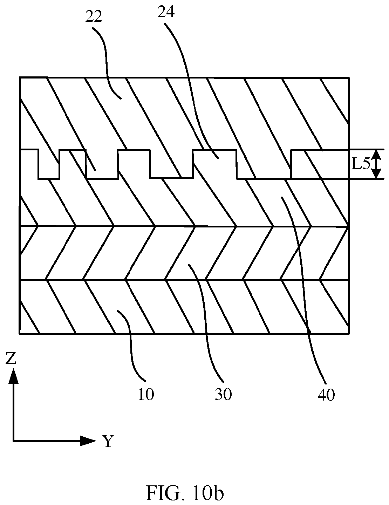

As shown in FIG. 6, each of the structural units 20 may include a plurality of fins 24. As shown in FIG. 10a and FIG. 10b, the fin 24 is a protruding structure formed between every two adjacent grooves after a plurality of grooves are etched through the barrier layer 40 to the channel layer 30. A difference between the semiconductor device shown in FIG. 10b and the semiconductor device shown in FIG. 10a lies in that a gate 21 in the semiconductor device shown in FIG. 10a is disposed on a first dielectric layer 71, and a gate 21 in the semiconductor device shown in FIG. 10b is disposed on the barrier layer 40.

As shown in FIG. 10a, a two-dimensional electron gas (Two-dimensional electron gas, 2DEG) 31 is formed between the barrier layer 40 and the channel layer 30, and the 2DEG 31 may refer to free electrons having two degrees of freedom in a three-dimensional solid. For example, movement of free electrons between the barrier layer 40 and the channel layer 30 in the semiconductor device is blocked in a Z direction, and the free electrons can only freely move in an X direction and a Y direction. A size of the 2DEG 31 in the X direction is the same as a size of the fin 24 in the X direction, and a size of the 2DEG 31 in the Y direction is the same as a size of the fin 24 in the Y direction. When a size of the fin 24 in a specific direction decreases, a size of the 2DEG 31 also decreases, and the 2DEG 31 is consumed more. Consequently, a threshold voltage of the structural unit 20 increases. In addition, when a size of the fin 24 in a specific direction decreases, a resistance value of the structural unit 20 increases, and a transconductance amplitude decreases. It may be learned that, the size of the fin 24 affects the threshold voltage and the transconductance amplitude of the structural unit 20, and consequently affects the transconductance curve. When the size of the fin 24 changes, the transconductance amplitude of the structural unit 20 changes, and a position of the transconductance curve in the horizontal coordinate also changes. There are at least two structural units 20 in the plurality of structural units 20. When a fin 24 of one structural unit 20 differs in size from a fin 24 of the other structural unit 20, transconductance amplitudes of the two structural units 20 are different, and positions of transconductance curves in a horizontal coordinate are different in a coordinate system. Therefore, the semiconductor device in this application includes at least two transconductance levels, and transconductance curves of at least two structural units 20 can be obtained. After the transconductance curves of the two structural units 20 are fused, a smooth transconductance curve in the middle may be obtained, and the transconductance curve is a transconductance curve of the semiconductor device. In addition, sizes of fins 24 of a large quantity of structural units 20 may be set to be different, to obtain more transconductance levels, thereby obtaining a smooth transconductance curve in a large range in the middle, and improving linearity of the semiconductor device.

The following describes in detail the components in the semiconductor device in embodiments of this application.

As shown in FIG. 4a, the substrate 10 has a first surface 11 and a second surface 12 opposite to the first surface 11. In an embodiment, a material of the substrate 10 includes silicon, silicon carbide, sapphire, gallium nitride, diamond, and the like. The channel layer 30 is disposed above the substrate 10 in the Z direction. In an embodiment, a material of the channel layer 30 includes InₓAl_{y}Ga_{z}N, where x≥0, y>0, and z=1-x-y. The barrier layer 40 is disposed above the channel layer 30 in the Z direction. In an embodiment, a material of the barrier layer 40 includes InₐAl_{b}Ga_{c}N, where a≥0, b>0, and c=1-a-b.

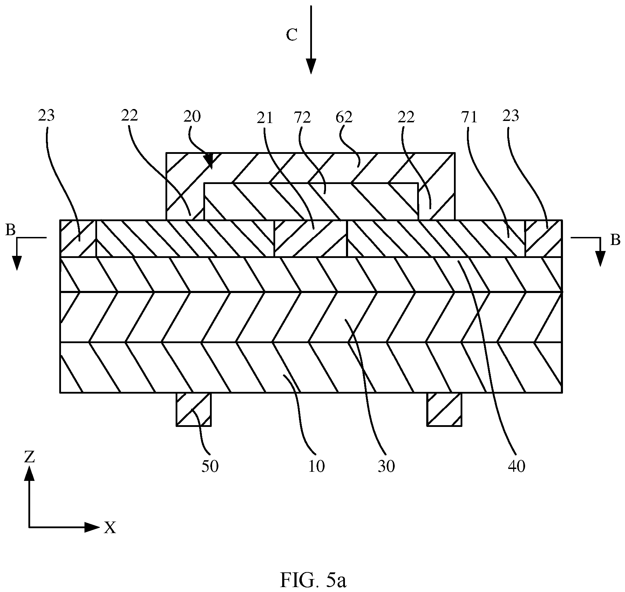

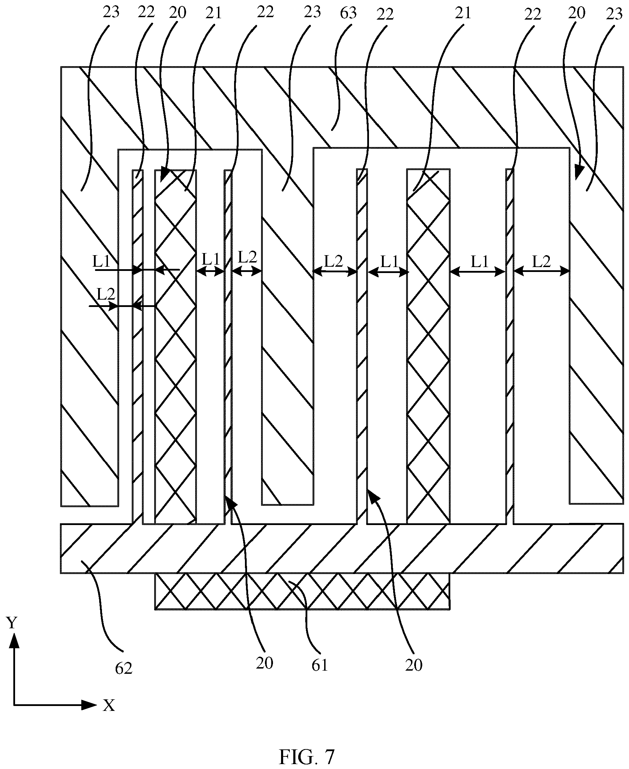

In an embodiment of this application, for example, as shown in embodiments of FIG. 5a and FIG. 4b, the plurality of structural units 20 are all disposed on one side of the substrate 10. As shown in FIG. 4b, the plurality of structural units 20 are all located on the barrier layer 40. In other words, the plurality of structural units 20 are all higher than the barrier layer 40 in the Z direction. As shown in FIG. 7, the plurality of structural units 20 are mutually connected in parallel, and the plurality of structural units 20 are sequentially arranged in the X direction and extend in the Y direction.

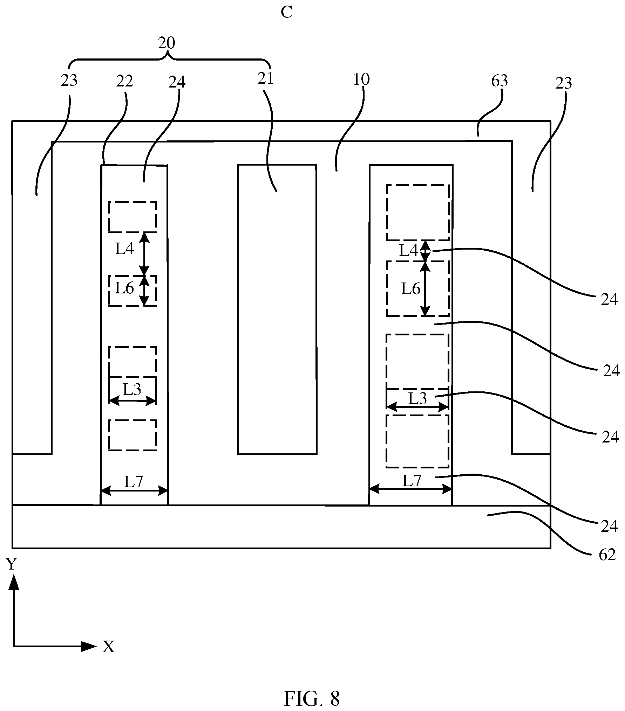

As shown in FIG. 8, each of the structural units 20 includes a source 21, a drain 23, a fin 24, and a gate 22. In each of the structural units 20, projections of the source 21 and the drain 23 on the substrate 10 are respectively located on two sides of a projection of the gate 22 on the substrate 10. As shown in FIG. 7, the source 21, the gate 22, and the drain 23 are all arranged in the X direction and extend in the Y direction. "Extend in the Y direction" should be understood as that a general extension direction is the Y direction. The sources 21 of the structural units 20 are connected, the drains 23 of the structural units 20 are connected, and the gates 22 of the structural units 20 are connected. For example, the semiconductor device may further include a gate connection part 62, a source connection part 61, and a drain connection part 63. The gate 22 in each of the structural units 20 is connected to the gate connection part 62, the source 21 in each of the unit structures is connected to the source connection part 61, and the drain 23 in each of the unit structures is connected to the drain connection part 63.

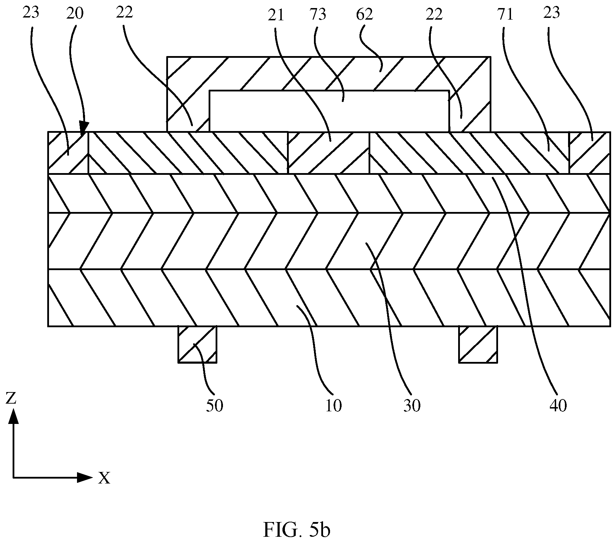

As shown in FIG. 4a, the source 21 and the drain 23 are located at a same layer, and both are in contact with the barrier layer 40, to form ohmic contact. As shown in FIG. 7, both the source connection part 61 and the drain connection part 63 are located at a same layer as the source 21 and the drain 23, and both the source connection part 61 and the drain connection part 63 are in contact with the barrier layer 40 (not shown in FIG. 4a). In an embodiment, thicknesses of the source 21, the source connection part 61, the drain 23, and the drain connection part 63 may be the same. As shown in FIG. 5b, a "thickness" may refer to a size in the Z direction, and when "thicknesses" of a plurality of components are the same, a specific process error or deviation may be allowed in the "thicknesses" of the plurality of components. Because the source 21, the source connection part 61, the drain 23, and the drain connection part 63 are all located at the same layer, when the thicknesses of the source 21, the source connection part 61, the drain 23, and the drain connection part 63 are the same, the source 21, the source connection part 61, the drain 23, and the drain connection part 63 may be manufactured at a time in a same process. In another embodiment, the thicknesses of the source 21 and the drain 23 may be the same, and the thicknesses of the source connection part 61 and the drain connection part 63 may be the same, but the thicknesses of the source 21 and the drain 23 may be different from the thicknesses of the source connection part 61 and the drain connection part 63.

In a possible implementation, as shown in FIG. 4a, the gate 22 may be in contact with the barrier layer 40 to form Schottky contact (Schottky). The Schottky contact means contact between metal and a semiconductor material. When the metal is in contact with the semiconductor material, an energy band of the semiconductor is bent at an interface, to form a Schottky barrier, and existence of the barrier causes a large interface resistance. In this solution, the gate 22, the source 21, and the drain 23 are all located at a same layer, and a first dielectric layer 71 may be disposed between the gate 22 and the source 21 and between the gate 22 and the drain 23, to implement physical isolation. The gate connection part 62 may be located on the gate 22 away from the barrier layer 40. In other words, the gate connection part 62 is higher than the gate 22, the source 21, and the drain 23 in the Z direction.

In another possible implementation, as shown in FIG. 5a, a first dielectric layer 71 may be disposed on the barrier layer. In addition, the first dielectric layer 71 is located between the source 21 and the drain 23, and the gate 22 is disposed on the first dielectric layer 71, to form a metal-insulator-semiconductor (Metal-insulator-semiconductor, MIS) structure. The first dielectric layer 71 may have a single layer, or may have a plurality of layers. In an embodiment, a total thickness of the first dielectric layer 71 may be the same as the thickness of the source 21 and the thickness of the drain 23. In another embodiment, a total thickness of the first dielectric layer 71 may be different from the thickness of the source 21 and the thickness of the drain 23. When the gate 22 is disposed on the first dielectric layer 71, the gate 22 is higher than the source 21 and the drain 23 in the Z direction. In this solution, a projection of the gate connection part 62 on the barrier layer 40 overlaps with a projection of the source 21 or the drain 23 on the barrier layer 40. Therefore, as shown in FIG. 5a, the gate connection part 62 may be physically isolated from the source 21 or the drain 23 by using a second dielectric layer 72. As shown in FIG. 5b, the gate connection part 62 may alternatively be physically isolated from the source 21 or the drain 23 by using an air bridge 73.

As shown in FIG. 7, a distance between the gate 22 and the source 21 in each of the plurality of structural units 20 is a first distance L1. In an embodiment, the first distance L1 is greater than or equal to 10 nm and less than or equal to 5000 nm. There are at least two structural units 20 in the plurality of structural units 20, and the first distance L1 in one structural unit 20 is different from the first distance L1 in the other structural unit 20. For example, a difference between the first distances L1 in different structural units 20 is greater than 5 nm.

In a possible implementation, there are some structural units 20, where the first distance L1 between the gate 22 and the source 21 in one of every two structural units 20 is different from the first distance L1 in the other structural unit 20. When two structural units 20 differ in the first distance L1 between the gate 22 and the source 21, resistance values of the two structural units 20 are different, and transconductance amplitudes are negatively correlated with the resistance values. Therefore, as shown in FIG. 9, when every two of three structural units 20 differ in the first distance L1, transconductance amplitudes of the three structural units 20 are different, positions of highest points of transconductance curves a of the three structural units 20 in a vertical coordinate are different. Therefore, when fins 24 of two structural units 20 differ in size, transconductance amplitudes of the two structural units 20 are different, and positions of transconductance curves in a horizontal coordinate are different. Therefore, when impact of the different first distances L1 between the gates 22 and the sources 21 in the two structural units 20 on the transconductance amplitudes is opposite to impact of the different sizes of the fins 24 on the transconductance amplitudes, it can be ensured as much as possible that a middle region is smooth after the transconductance curves of the two structural units 20 are fused. Therefore, it should be noted that a difference between transconductance amplitudes of different structural units 20 may be greater than 1%.

In another possible implementation, the first distances L1 in the plurality of structural units 20 are different. For example, in an embodiment, the semiconductor device includes four structural units 20, and the first distances L1 in the four structural units 20 are different. In this way, transconductance amplitudes of the structural units 20 are different. In other words, positions of transconductance curves of the structural units 20 in a vertical coordinate are different. Therefore, the semiconductor device may obtain at least a same quantity of transconductance curves as that of the structural units 20, so that the middle of the transconductance curve of the semiconductor device may be further made smoother.

As shown in FIG. 7, in a possible implementation, in the plurality of structural units 20, a distance between the gate 22 and the drain 23 in each of the structural units 20 is a second distance L2. In an embodiment, the second distance L2 is greater than or equal to 10 nm and less than or equal to 5000 nm. There are at least two structural units 20 in the plurality of structural units, and the second distance L2 between the gate 22 and the drain 23 in one structural unit 20 is different from the second distance L2 in the other structural unit 20. For example, a difference between the second distances L2 in different structural units 20 is greater than 5 nm.

In a possible implementation, there are some structural units 20, where the second distance L2 between the gate 22 and the drain 23 in one of every two structural units 20 is different from the second distance L2 in the other structural unit 20. Because the semiconductor device is usually of a symmetric structure with a center of the semiconductor device, a case in which the semiconductor device is incorrectly assembled may exist. Because the source 21 and the drain 23 are made of a same material, when the semiconductor device is incorrectly assembled, the source 21 may be used as the drain 23, and the drain 23 may also be used as the source 21. In this case, when the second distance L2 between the gate 22 and the drain 23 in one structural unit 20 is different from the second distance L2 in the other structural unit 20, the distance between the gate 22 and the source 21 in one structural unit 20 can still be different from the distance between the gate 22 and the source 21 in the other structural unit 20. Therefore, the middle of the transconductance curve a3 of the semiconductor device can be smooth.

In another possible implementation, the second distances L2 in the structural units 20 are different. For example, as shown in FIG. 7, the semiconductor device includes four structural units 20, and the second distances L2 in the four structural units 20 are different. In this way, transconductance amplitudes of the structural units 20 are different. In other words, positions of transconductance curves of the structural units 20 in a vertical coordinate are different. Therefore, the semiconductor device may obtain at least a same quantity of transconductance curves as that of the structural units 20. When positions of the transconductance curves of the structural units 20 in a horizontal coordinate are different, the middle of the transconductance curve a3 of the semiconductor device may be further made smoother.

As shown in FIG. 10a, in this embodiment, there are a plurality of fins 24, and the plurality of fins 24 are all disposed on the barrier layer 40. Specifically, in a process of manufacturing the semiconductor device in this embodiment of this application, after the substrate 10, the channel layer 30, and the barrier layer 40 are successively manufactured, a plurality of grooves are etched in the barrier layer 40 by using an etching process, and a protrusion formed between each plurality of adjacent grooves is the fin 24. In another embodiment, there may alternatively be one fin 24. In this embodiment of this application, the plurality of grooves etched in the barrier layer 40 are used to form at least one fin 24. It should be understood that the plurality of grooves in the barrier layer 40 may be formed only in the barrier layer 40, or may be formed in the channel layer 30 and the barrier layer 40. The first dielectric layer 71 is further disposed on the barrier layer 40 in which the fin 24 is formed. The first dielectric layer 71 may form a protruding part at a corresponding position in which the fin 24 is disposed, as shown in the embodiment in FIG. 10a, or may not form a protruding part at a corresponding position. It should be understood that, when the first dielectric layer 71 forms the protruding part at the corresponding position in which the fin 24 is disposed, a size (for example, a width, and/or a length, and/or a thickness) of the protruding part may be the same as or similar to a size (for example, a width, and/or a length, and/or a thickness) of the corresponding fin 24, or a size of the protruding part may be different from but be positively correlated with a size of the corresponding fin 24.

As shown in FIG. 8, a projection of the fin 24 on the substrate 10 is located within a range of the projection of the gate 22 on the substrate 10, and the plurality of fins 24 are arranged in an extension direction of the gate 22. Because the gate 22 extends in the Y direction, the plurality of fins 24 are also arranged in the Y direction.

In this embodiment, sizes of fins 24 in a same structural unit 20 are the same, and sizes of fins 24 in different structural units 20 are different. It should be understood that sizes of different fins 24 include at least one of a size L3 in the X direction, a size L4 in the Y direction, and a size L5 in the Z direction.

In a possible implementation, sizes of fins 24 of different structural units 20 in one direction are different. For example, as shown in FIG. 8, sizes L3 of fins 24 of different structural units 20 in the X direction are different; and/or as shown in FIG. 8, sizes L4 of fins 24 of different structural units 20 in the Y direction are different; and/or sizes L5 of fins 24 of different structural units 20 in the Z direction are different. For example, as shown in FIG. 10a, sizes L5 of fins 24 of each of the structural units 20 in the Z direction are the same, and sizes L5 of fins 24 of at least two structural units 20 in the Z direction are different. Because FIG. 10a is a view obtained after stepped sectioning is performed from a position A in FIG. 6, FIG. 6 includes two structural units 20, two fins 24 located on a left side in FIG. 10a belong to one of the structural units, and sizes L5 of the two fins 24 in the Z direction are the same; and two fins 24 located on a right side belong to the other structural unit 20, sizes of the two fins 24 in the Z direction are the same, and the sizes L5 of the two fins 24 located on the left side in the Z direction are different from the sizes L5 of the two fins located on the right side in the Z direction. The "left side" may be a side away from the Y direction, and the "right side" may be a side pointed to by the Y direction. When fins 24 of different structural units 20 differ in size in the X direction or the Y direction, because both the X direction and the Y direction are perpendicular to the Z direction, the fins 24 of the structural units 20 may be manufactured under a same etching process when the semiconductor device in this application is manufactured. Therefore, the quantity of transconductance levels of the semiconductor device may be increased without increasing a process flow.

In another possible implementation, sizes of fins 24 of different structural units 20 are different in two directions. For example, as shown in FIG. 8, sizes L3 of fins 24 of different structural units 20 in the X direction are different, and sizes L4 of fins 24 of different structural units 20 in the Y direction are different; or sizes L3 of fins 24 of different structural units 20 in the X direction are different, and sizes L5 of fins 24 of different structural units 20 in the Z direction are different; or sizes L4 of fins 24 of different structural units 20 in the Y direction are different, and sizes L5 of fins 24 of different structural units 20 in the Z direction are different. Because the fins 24 are obtained after the barrier layer 40 is etched, and limited by photoetching precision, it is difficult to process a plurality of fins 24 having different sizes if only sizes of the fins 24 in the X direction, the Y direction, or the Z direction are adjusted. Therefore, sizes in a plurality of directions are combined to adjust the sizes of the fins 24, so that the solution is easier to implement. When the fins 24 of the structural units 20 differ in size in the X direction and the Y direction, because both the X direction and the Y direction are perpendicular to the Z direction, the fins 24 of the structural units 20 may be manufactured under a same etching process when the semiconductor device in this application is manufactured. Therefore, the quantity of transconductance levels of the semiconductor device may be increased without increasing a process flow.

In another possible implementation, sizes of fins 24 of different structural units 20 in three directions are different. For example, sizes of different fins 24 in the X direction, the Y direction, and the Z direction are different.

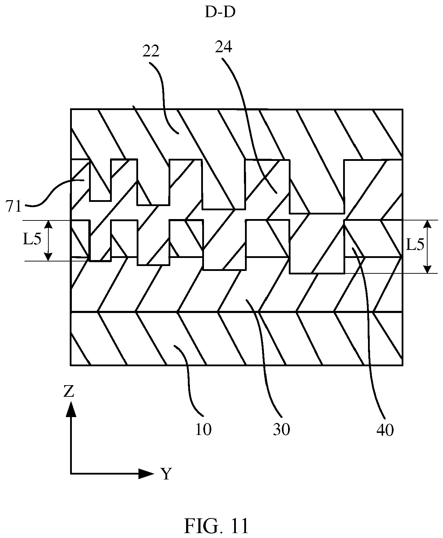

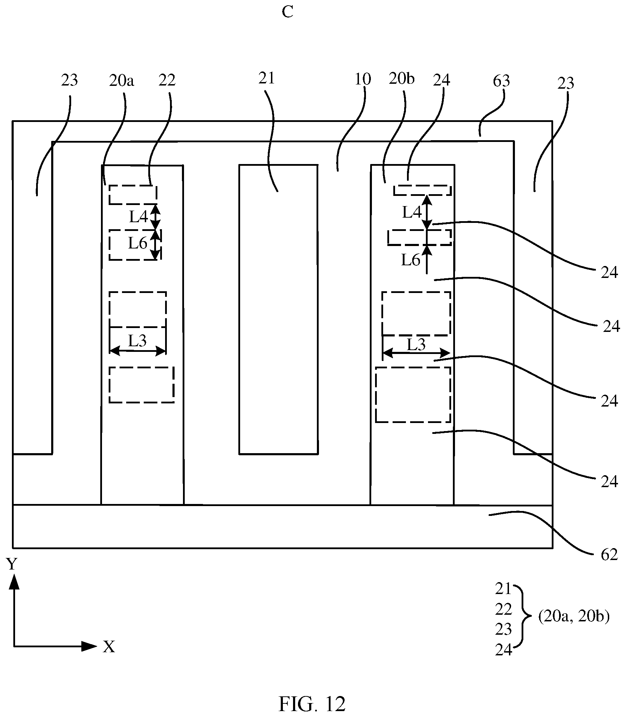

In another embodiment, sizes of a plurality of fins 24 in a same structural unit 20 are different from each other, and sizes of a plurality of fins 24 in a same structural unit 20 in one direction are different. For example, as shown in FIG. 11, sizes L5 of a plurality of fins 24 in a same structural unit 20 in the Z direction are different. Alternatively, sizes of a plurality of fins 24 in a same structural unit 20 in two directions are different. For example, as shown in FIG. 12, the semiconductor device includes two structural units 20, each of the structural units 20 includes four fins 24, sizes L3 of the four fins 24 in the X direction are different, and sizes L4 of the four fins 24 in the Y direction are also different. Alternatively, sizes of a plurality of fins 24 in a same structural unit 20 in the X direction, the Y direction, and the Z direction are different. A size of the fin 24 affects a threshold voltage of the structural unit 20. Therefore, when sizes of fins 24 in a same structural unit 20 are different, threshold voltages of parts corresponding to different fins 24 in the same structural unit 20 are different. Therefore, positions of transconductance curves of the parts corresponding to the different fins 24 in the same structural unit 20 in a horizontal coordinate are different, and a quantity of transconductance levels of each of the structural units 20 may be increased. Sizes of fins 24 of different structural units 20 are also different from each other. Therefore, positions of transconductance curves of the different structural units 20 in a coordinate system are different. Therefore, the quantity of transconductance levels of the semiconductor device may be further increased.

As shown in FIG. 12, in this embodiment, in each structural unit 20, there are at least three fins 24, and at least two spacings L6 are different in spacings L6 between every two adjacent fins 24. It should be noted that, when a size of the semiconductor device in the Y direction is fixed, a sum of the size of each fin 24 in the Y direction and the spacing L6 between every two fins 24 remains unchanged, and when the size of the fin 24 in the Y direction changes, the spacing L6 between the two fins 24 also changes.

In a possible implementation, in a same structural unit 20, a portion of the spacings L6 are different from each other, and another portion of the spacings L6 are the same. When the spacings L6 between two adjacent fins 24 are different, regions corresponding to the spacings L6 between two fins 24 in the structural unit 20 differ in transconductance. Therefore, when there are at least two different spacings L6 in the structural unit 20, the structural unit 20 has at least two threshold voltages, and the structural unit 20 has at least two transconductance curves. This may further increase the quantity of transconductance levels of the semiconductor device.

In another possible implementation, as shown in FIG. 12, the spacings L6 in a same structural unit 20 are different. In this way, a quantity of transconductance levels of the structural unit 20 is the same as that of the spacings L6. This may further increase the quantity of transconductance levels of the structural unit 20, and further increase the quantity of transconductance levels of the semiconductor device.

As shown in FIG. 12, in the plurality of structural units 20, there are at least two structural units 20 in which at least one spacing L6 in one structural unit 20 is different from at least one spacing L6 in the other structural unit 20.

In an optional implementation, in a portion of the structural units 20, spacings L6 in every two structural units 20 are different from each other, and spacings L6 in another portion of the structural units 20 are the same. For example, the semiconductor device includes three structural units 20 that are respectively named a structural unit 1, a structural unit 2, and a structural unit 3, and there are four mutually different spacings L6 in each of the three structural units 20. The four spacings L6 in the structural unit 1 are different from the four spacings L6 in the structural unit 2, and the four spacings L6 in the structural unit 2 are respectively the same as the four spacings L6 in the structural unit 3.

In another optional implementation, as shown in FIG. 12, in the plurality of structural units 20, spacings L6 in every two structural units 20 are different from each other. For example, the semiconductor device includes two structural units 20, namely, a structural unit 20a and a structural unit 20b. Four spacings L6 in the structural unit 20a are different from four spacings L6 in the structural unit 20b.

In another optional implementation, in a portion of the structural units 20, a portion of the spacings L6 in every two structural units 20 are the same, and another portion of the spacings L6 are different from each other; and in another portion of the structural units 20, the spacings L6 in every two structural units 20 are the same or different. For example, two spacings L6 in the structural unit 1 are the same as two spacings L6 in the structural unit 2, and the other two spacings L6 in the structural unit 1 are different from the other two spacings L6 in the structural unit 2. The four spacings L6 in the structural unit 2 are respectively the same as or different from the four spacings L6 in the structural unit 3.

In another optional implementation, in every two of the plurality of structural units 20, a portion of the spacings L6 are the same, and another portion of the spacings L6 are different from each other. For example, two spacings L6 in the structural unit 1, two spacings L6 in the structural unit 2, and two spacings L6 in the structural unit 3 are the same, and the other two spacings L6 in the structural unit 1, the other two spacings L6 in the structural unit 2, and the other two spacings L6 in the structural unit 3 are different from each other.

In another embodiment, spacings L6 in a same structural unit 20 are the same. Spacings L6 in every two of the plurality of structural units 20 are different from each other. Alternatively, a portion of spacings L6 in every two of a portion of the structural units 20 are the same, and spacings L6 in every two of another portion of the structural units 20 are different from each other. For example, the four spacings L6 in the structural unit 1 are the same, the four spacings L6 in the structural unit 2 are the same, the four spacings L6 in the structural unit 3 are the same, the spacings L6 in the structural unit 1 are the same as the spacings L6 in the structural unit 2, and the spacings L6 in the structural unit 2 are different from the spacings L6 in the structural unit 3.

As shown in FIG. 8, in at least one of the structural units 20, a size L7 of the gate 22 in the X direction is positively correlated with the size L3 of the fin 24 in the X direction, and the gate 22 extends in the Y direction. When the sizes L3 of the fins 24 in a same structural unit 20 in the X direction are the same, for different structural units 20, the larger sizes L3 of the fins 24 in the X direction indicate the larger size L7 of the gate 22 in the X direction. When the sizes L3 of the fins 24 in a same structural unit 20 in the X direction are different, in the structural unit 20, the size L7 of the gate 20 in the X direction changes with the sizes L3 of the fins 24 in the X direction. Because the projection of the fin 24 on the substrate 10 is located within the range of the projection of the gate 22 on the substrate 10, and the size L3 of the fin 24 in the X direction affects the transconductance amplitude of the structural unit 20, when the size L7 of the gate 22 in the X direction increases, the transconductance amplitude of the structural unit 20 decreases. Therefore, after the size L3 of the fin 24 in the X direction is determined, the size L7 of the gate 22 in the X direction may be determined, thereby reducing waste of the gate 22 and impact on performance of the semiconductor device caused by an increase in the size L7 of the gate 22 in the X direction when the size L3 of the fin 24 in the X direction is reduced.

As shown in FIG. 8, in an optional implementation, the size L7 of the gate 22 of each of the structural units 20 in the X direction is positively correlated with the size L3 of the fin 24 in the X direction. In an embodiment, a difference between the sizes L7 of the gates 22 of different structural units 20 in the X direction is greater than 5 nm.

In another optional implementation, the size L7 of the gate 22 in a portion of the structural units 20 in the X direction is positively correlated with the size L3 of the fin 24 in the X direction, and the size L7 of the gate 22 in another portion of the structural units 20 in the X direction is negatively correlated, or neither is positively correlated nor is negatively correlated with the size L3 of the fin 24 in the X direction.

As shown in FIG. 8, in at least one of the structural units 20, the size L3 of the fin 24 in the X direction is less than the size L7 of the gate 22 in the X direction. The size L7 of the gate 22 in the X direction is greater than or equal to 10 nm and less than or equal to 2000 nm. When the size of the fin 24 in the X direction is fixed, an increase in the size L7 of the gate 22 in the X direction reduces the performance of the semiconductor device. Therefore, according to different process capabilities, a difference between the size L7 of the gate 22 in the X direction and the size L3 of the fin 24 in the X direction is greater than or equal to 10 nm and less than or equal to 1 um. In this way, the gate 22 in the unit structure may be considered to wrap the fin 24, so that a capability of controlling a channel by the gate 22 can be increased, electric leakage of the semiconductor device is reduced, and stability of a threshold voltage of the structural unit 20 is improved.

As shown in FIG. 8, in an optional implementation, the size L3 of the fin 24 in each of the structural units 20 in the X direction is less than the size L7 of the gate 22 in the X direction. In another optional implementation, the size L3 of the fin 24 in a portion of the structural units 20 in the X direction is less than the size L7 of the gate 22 in the X direction, and the size L3 of the fin 24 in another portion of the structural units 20 in the X direction is the same as the size L7 of the gate 22 in the X direction.

As shown in FIG. 4a, in this embodiment, a quantity of electrodes 50 is the same as that of the structural units 20, and projections of the electrodes 50 on the first surface 11 are in one-to-one correspondence and overlap with projections of the gates 22 of the structural units 20 on the first surface 11. When the semiconductor device is used, different voltages may be applied to the electrodes 50 respectively, and the voltages may be transferred to regions that are of the substrate 10 and that correspond to the electrodes 50, so that the substrate 10 in different regions has different voltages of the substrate 10, and a difference between the voltages of the substrate 10 in different structural units 20 may be greater than 0.1 V. The threshold voltage of the structural unit 20 is negatively correlated with the voltage of the substrate 10. Because the projections of the electrodes 50 on the first surface 11 are in one-to-one correspondence with and overlap with the projections of the gates 22 in the structural units 20 on the first surface 11, the threshold voltages of the structural units 20 are different. Therefore, another method for regulating the threshold voltage of the structural unit 20 may be provided. In another embodiment, the quantity of electrodes 50 is less than that of the structural units 20.

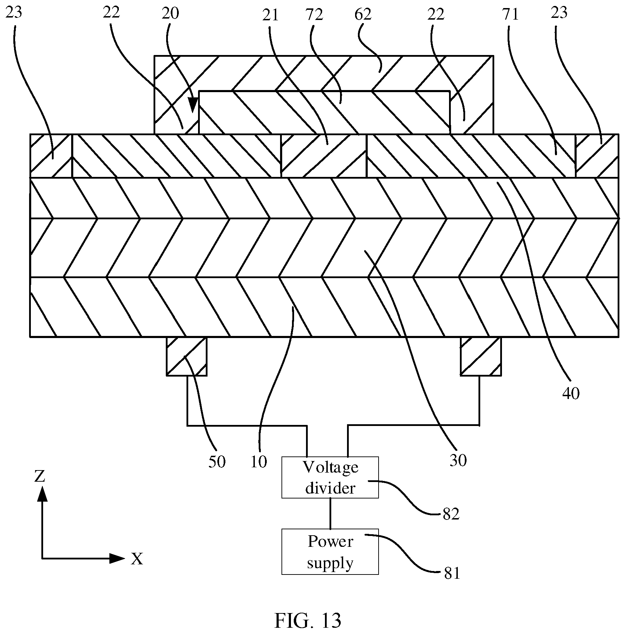

As shown in FIG. 13, in a possible implementation, the circuit board includes a power supply 81 and a voltage divider 82. The power supply 81 is electrically connected to the voltage divider 82, and the voltage divider 82 is further electrically connected to the electrodes 50. In this way, the voltage divider 82 may divide an output voltage of the power supply 81, and provide different voltages for the electrodes 50. Therefore, different voltages of the substrate 10 may be provided for different regions of the substrate 10.

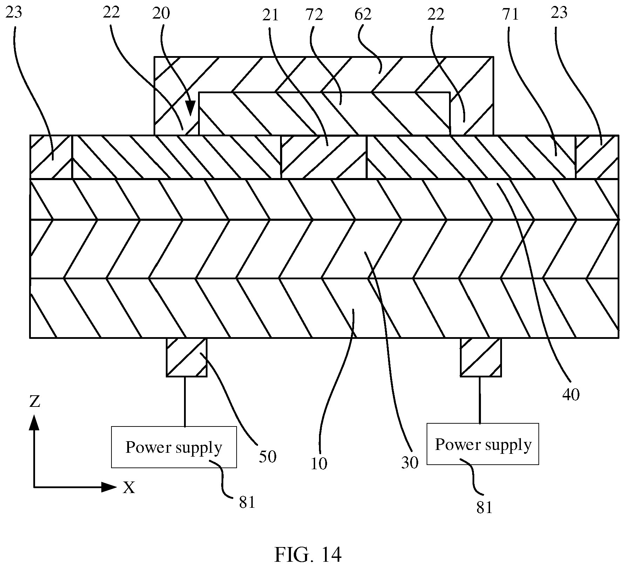

As shown in FIG. 14, in another possible implementation, the circuit board includes a plurality of power supplies 81, a quantity of power supplies 81 is the same as that of the electrodes 50, and each power supply 81 provides different voltages for the electrodes 50. Therefore, different voltages of the substrate 10 may be provided for different regions of the substrate 10.

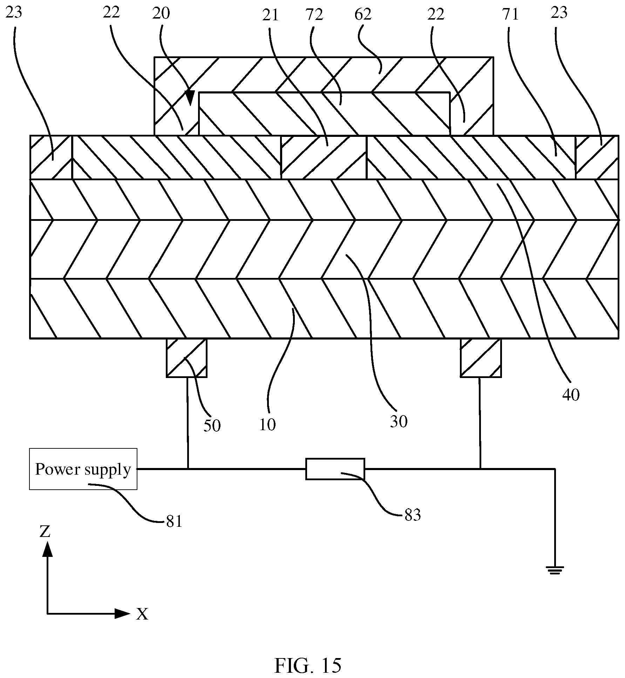

As shown in FIG. 15, in another possible implementation, the circuit board includes a power supply 81 and a plurality of resistors 83. The plurality of resistors 83 are electrically connected to the power supply 81. A quantity of resistors 83 is the same as that of the electrodes 50. The resistors 83 are electrically connected to the electrodes 50 in one-to-one correspondence. Each of the resistors 83 differs in value of the resistor 83. In this way, each of the resistors 83 may separately perform voltage division on the power supply 81, and provide mutually different voltages to the electrodes 50. Therefore, different voltages of the substrate 10 may be provided for different regions of the substrate 10.

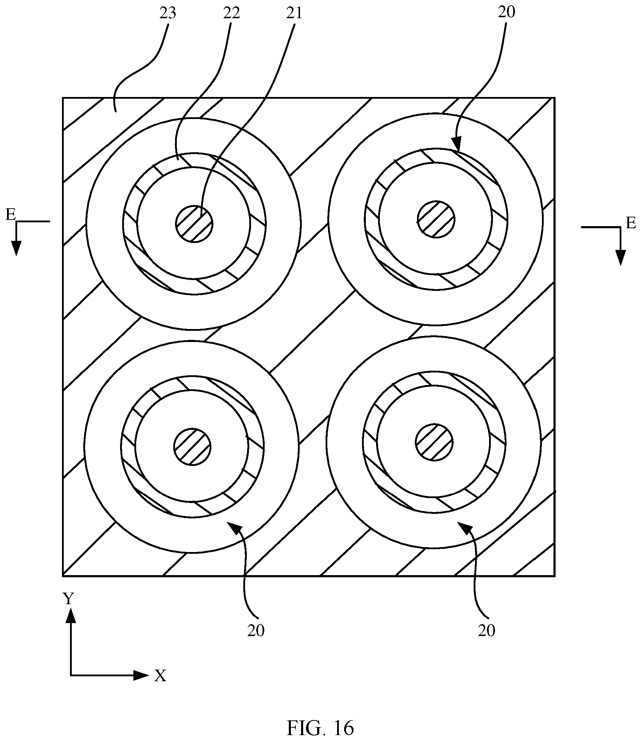

A difference between the embodiment shown in FIG. 16 and embodiments shown in FIG. 4a and FIG. 7 lies in shapes of the gate 22, the source 21, and the drain 23, an arrangement manner of the structural units 20, and a spatial arrangement manner of the gate connection part 62 and the drain connection part 63. In the embodiment shown in FIG. 4a, the gate 22, the source 21, and the drain 23 all extend in the Y direction. In this embodiment, as shown in FIG. 16, a shape of the projection of the source 21 in each of the structural units 20 on the substrate 10 is a circle, and shapes of the projections of the gate 22 and the drain 23 on the substrate 10 are both rings, and may be specifically circular rings.

In the embodiment shown in FIG. 7, the plurality of structural units 20 are sequentially arranged in the X direction. In this embodiment, as shown in FIG. 16, the plurality of structural units 20 are arranged in a rectangular array manner. In another embodiment, the plurality of structural units 20 may alternatively be arranged in a straight line, or arranged in a circular array, or the like.

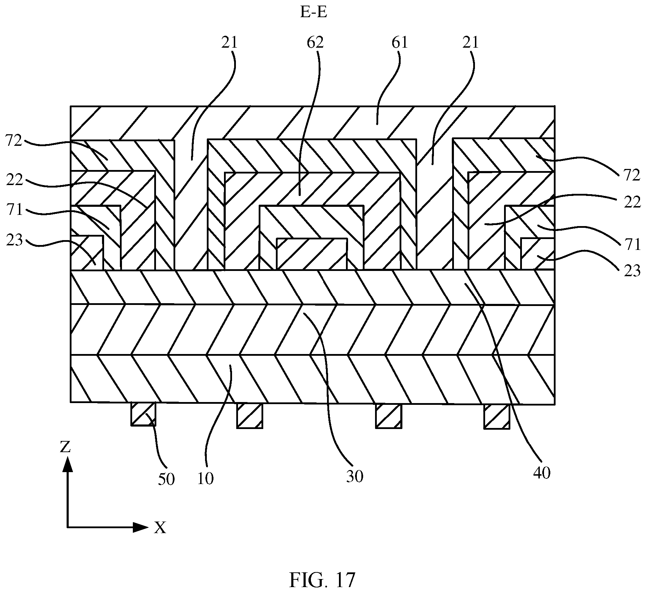

In the embodiment shown in FIG. 4a, the source connection part 61 and the drain connection part 63 are located at a same layer, and the gate connection part 62 is higher than the source connection part 61. In this embodiment, as shown in FIG. 17, the source connection part 61, the gate connection part 62, and the drain 23 are located at different layers. The drain 23 and the drain connection part 63 (not shown in FIG. 17) are located at a same layer. For example, the drain 23 is disposed on the barrier layer 40, the gate connection part 62 is higher than the drain 23, and the gate connection part 62 is electrically isolated from the drain 23 by using the first dielectric layer 71; and the source connection part 61 is higher than the gate connection part 62, and the source connection part 61 is electrically isolated from the gate connection part 62 by using the second dielectric layer 72. That is, the semiconductor device sequentially includes the electrode 50, the substrate 10, the channel layer 30, the barrier layer 40, the drain 23, the source 21, the gate 22, the first dielectric layer 71, the gate connection part 62, the second dielectric layer 72, and the source connection part 61 in the Z direction, where the drain 23, the source 21, and the gate 22 are located at a same layer.

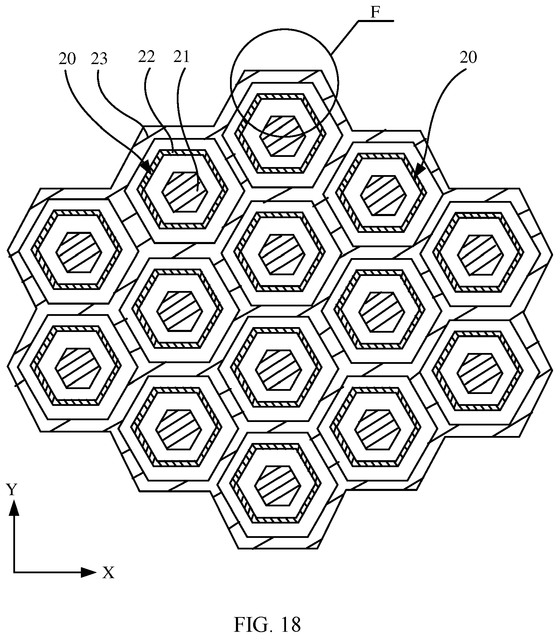

An embodiment shown in FIG. 18 differs from the embodiment shown in FIG. 16 in that shapes of the projections of the gate 22, the source 21, and the drain 23 on the substrate 10 are different. In the embodiment shown in FIG. 16, the shape of the projection of the source 21 on the substrate 10 is a circle, and the shapes of the projections of the gate 22 and the drain 23 on the substrate 10 are both circular rings. In this embodiment, as shown in FIG. 18, a shape of the projection of the source 21 in each of the structural units 20 on the substrate 10 is a polygon, for example, may be a hexagon, and shapes of the projections of the gate 22 and the drain 23 on the substrate 10 are both ring-shaped polygons, for example, may be ring-shaped hexagons. In another embodiment, in a portion of the structural units 20, shapes of the projections of the source 21, the gate 22, and the drain 23 on the substrate 10 are ring-shaped polygons; and in another portion of the structural units 20, shapes of the projections of the source 21, the gate 22, and the drain 23 on the substrate 10 are circular rings. For one structural unit 20, a shape of the projection of one of the gate 22, the source 21, and the drain 23 on the substrate 10 is a ring-shaped polygon, and shapes of the projections of the other two on the substrate 10 are circular rings; or shapes of the projections of two of the gate 22, the source 21, and the drain 23 on the substrate 10 are ring-shaped polygons, and a shape of the projection of the remaining one on the substrate 10 is a circular ring.

In each of the unit structures, a shape of the projection of the drain 23 on the substrate 10 is a ring-shaped regular polygon. In this way, edges of every two adjacent structural units 20 may fit together, so that utilization of a material of the substrate 10 by the plurality of structural units 20 can be increased, and waste of the material of the substrate 10 can be reduced. Similarly, when the shape of the projection of the drain 23 on the substrate 10 is a ring-shaped regular polygon, utilization of the material of the substrate 10 by the plurality of structural units 20 can also be increased, and waste of the material of the substrate 10 can be reduced. For example, projections of the plurality of structural units 20 on the substrate 10 account for more than 10% of the second surface 12.

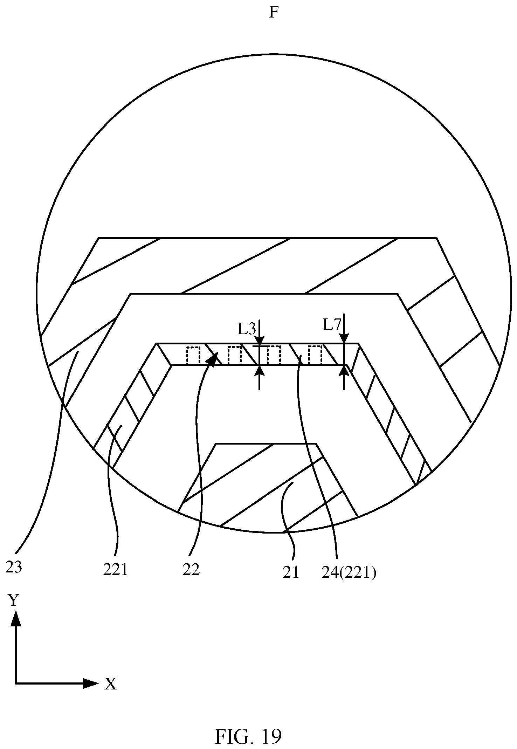

As shown in FIG. 19, in each of the unit structures, the gate 22 includes a plurality of sub-gates 221 that are sequentially connected end to end, a projection of each of the sub-gates 221 on the substrate 10 surrounds projections of the plurality of fins 24 on the substrate 10, and the plurality of fins 24 are arranged in an extension direction of the sub-gate 221. There are a plurality of fins 24 in at least one of the structural units 20. Therefore, sizes of the plurality of fins 24 in the structural unit 20 may be further set to different sizes, so that one structural unit 20 obtains a plurality of threshold voltages, and the structural unit 20 obtains a plurality of transconductance levels, thereby further increasing the quantity of transconductance levels of the semiconductor device.

In each of the structural units 20, a size L7 of the sub-gate 221 in a direction perpendicular to the extension direction of the sub-gate 221 is positively correlated with the size L3 of the fin 24 in the direction perpendicular to the extension direction of the sub-gate 221. Because the projection of the fin 24 on the substrate 10 is located within the range of the projection of the gate 22 on the substrate 10, and the size L3 of the fin 24 affects the transconductance amplitude of the structural unit 20, when the size L7 of the sub-gate 221 increases, the transconductance amplitude of the structural unit 20 decreases. Therefore, after the size L3 of the fin 24 is determined, the size L7 of the sub-gate 221 may be determined, thereby reducing waste of the sub-gate 221 and impact on performance of the semiconductor device caused by an increase in the size L7 of the sub-gate 221 when the size L3 of the fin 24 is reduced.

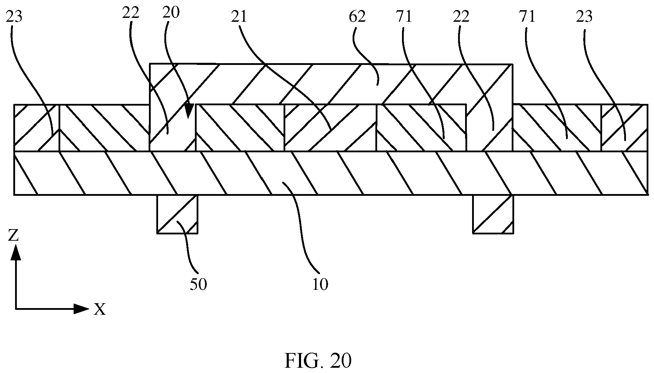

A difference between an embodiment shown in FIG. 20 and the embodiment shown in FIG. 4a lies in that, based on the embodiment shown in FIG. 4a, the channel layer 30 and the barrier layer 40 are removed from the semiconductor device in this embodiment. That is, in this embodiment, the semiconductor device includes the electrode 50, the substrate 10, and the plurality of structural units 20. It should be noted that, in another possible implementation, the channel layer 30 or the barrier layer 40 may be removed from the semiconductor device based on FIG. 4a.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make many modifications without departing from the purposes of this application and the protection scope of the claims, and all the modifications shall fall within the protection of this application.

## Claims

1. A semiconductor device, comprising: a substrate and a plurality of structural units, wherein the plurality of structural units are all disposed on one side of the substrate;
each of the structural units comprises a source, a drain, a fin, and a gate, the sources of the structural units are connected, the drains of the structural units are connected, and the gates of the structural units are connected; and in each of the structural units, projections of the source and the drain on the substrate are respectively located on two sides of a projection of the gate on the substrate, the fin is disposed on the substrate, and a projection of the fin on the substrate is located within a range of the projection of the gate on the substrate; and
a fin of a first structural unit and a fin of a second structural unit in the plurality of structural units differ in size.

2. The semiconductor device according to claim 1, wherein sizes of the fins of each of the structural units are different.

3. The semiconductor device according to claim 1 or 2, wherein the size of the fin comprises at least one of a size in a first direction, a size in a second direction, and a size in a thickness direction, and both the first direction and the second direction are perpendicular to the thickness direction.

4. The semiconductor device according to any one of claims 1 to 3, wherein a first distance between the gate and the source in the first structural unit is different from the first distance in the second structural unit.

5. The semiconductor device according to claim 4, wherein the first distances in each of the structural units are different.

6. The semiconductor device according to any one of claims 1 to 5, wherein a second distance between the gate and the drain in the first structural unit is different from the second distance in the second structural unit.

7. The semiconductor device according to claim 6, wherein the second distances in each of the structural units are different.

8. The semiconductor device according to any one of claims 1 to 7, wherein the semiconductor device comprises at least two electrodes, and the two electrodes are disposed on a first surface that is of the substrate and that is away from the structural units; and
a projection of the gate in the first structural unit on the first surface overlaps with one of the electrodes, and a projection of the gate in the second structural unit on the first surface overlaps with another of the electrodes.

9. The semiconductor device according to claim 8, wherein a quantity of electrodes is the same as a quantity of structural units, and projections of the electrodes on the first surface are in one-to-one correspondence with projections of the gates in the structural units on the first surface.

10. The semiconductor device according to any one of claims 1 to 9, wherein the plurality of structural units are arranged in the first direction; and
in at least one of the structural units, the source, the gate, and the drain are all arranged in the first direction and extend in the second direction, there are a plurality of fins, the plurality of fins are arranged in an extension direction of the gate, and there is an included angle between the second direction and the first direction.

11. The semiconductor device according to any one of claims 1 to 9, wherein in at least one of the structural units:
a shape of the projection of at least one of the gate, the source, and the drain on the substrate is a ring; and
there are a plurality of fins, and the plurality of fins are arranged in an extension direction of the gate.

12. The semiconductor device according to any one of claims 1 to 11, wherein in at least one of the structural units, a size of the gate in the first direction is positively correlated with the size of the fin in the first direction, and the first direction is perpendicular to the extension direction of the gate.

13. The semiconductor device according to claim 12, wherein in at least one of the structural units, the size of the fin in the first direction is less than the size of the gate in the first direction.

14. The semiconductor device according to any one of claims 1 to 9, wherein in at least one of the structural units:
a shape of the projection of at least one of the gate, the source, and the drain on the substrate is a ring-shaped polygon; and
there are a plurality of fins, the gate comprises a plurality of sub-gates that are sequentially connected end to end, a projection of each of the sub-gates on the substrate surrounds projections of the plurality of fins on the substrate, and the plurality of fins are arranged in an extension direction of the sub-gate.

15. The semiconductor device according to claim 14, wherein in at least one of the structural units, a size of the sub-gate in the first direction is positively correlated with the size of the fin in the first direction, and the first direction is perpendicular to the extension direction of the sub-gate.

16. The semiconductor device according to any one of claims 1 to 9, 14 or 15, wherein in at least one of the structural units, a shape of the projection of at least one of the gate, the source, and the drain on the substrate is a ring-shaped regular polygon.

17. The semiconductor device according to any one of claims 1 to 16, wherein a spacing between two adjacent fins in the first structural unit is different from a spacing between two adjacent fins in the second structural unit.

18. The semiconductor device according to claim 17, wherein the spacings in each of the structural units are different.

19. An electronic device, comprising a circuit board and the semiconductor device according to any one of claims 1 to 18, wherein the semiconductor device is electrically connected to the circuit board.
